# EUROPÄISCHE PATENTSCHRIFT

(11) **EP 3 011 578 B1**
(45) Veröffentlichungstag und Bekanntmachung des Hinweises auf die Patenterteilung: **13.09.2017**
(21) Anmeldenummer: 14734762.9
(22) Anmeldetag: 18.06.2014
(51) Int. Cl.: H01H 9/16, H03K 17/18

(54) **ÜBERWACHUNGSSCHALTUNG ZUM ERKENNEN EINES SCHALTZUSTANDES EINES ELEKTRISCHEN SCHALTKONTAKTES UND VERFAHREN HIERZU**
MONITORING CIRCUIT FOR DETECTING A SWITCHING STATE OF AN ELECTRICAL SWITCHING CONTACT AND METHOD THEREFORE
CIRCUIT DE SURVEILLANCE SERVANT À DÉTECTER UN ÉTAT DE COMMUTATION D'UN CONTACT ÉLECTRIQUE ET PROCÉDÉ CORRESPONDANT

(30) Priorität: 21.06.2013 DE 102013106487
(43) Veröffentlichungstag der Anmeldung: 27.04.2016
(73) Patentinhaber: Wago Verwaltungsgesellschaft mbH, 32423 Minden (DE)
(72) Erfinder: VOSS, Christian, 32427 Minden (DE)
(74) Vertreter: Hess, Peter K. G.
(86) Internationale Anmeldenummer: PCT/EP2014/062817
(87) Internationale Veröffentlichungsnummer: WO 2014/202660

(56) Entgegenhaltungen:
- DE-A1- 2 806 294
- FR-A1- 2 632 138

## Beschreibung

Die Erfindung betrifft eine Überwachungsschaltung zum Erkennen eines Schaltzustandes eines elektrischen Schaltkontaktes in einem Stromversorgungspfad für mindestens einen elektrischen Verbraucher, wobei die Überwachungsschaltung eine Überwachungseinheit hat.

Die Erfindung betrifft weiterhin ein Verfahren zur Erkennung eines Schaltzustandes eines elektrischen Schaltkontaktes in einem Stromversorgungspfad für mindestens einen elektrischen Verbraucher.

In Sicherheitsschaltgeräten ist es erforderlich, den Zustand von elektrischen Schaltern zu ermitteln, um Kontaktfehler, wie insbesondere ein Verschweißen der Kontakte zu erkennen. Unter dem Schaltzustand eines elektrischen Schalters (elektrischen Schaltkontaktes) wird verstanden, ob die Schaltkontakte geöffnet oder geschlossen sind. Aber auch der Kontaktübergangswiderstand der Schaltkontakte wird im weitesten Sinne als Schaltzustand verstanden.

Herkömmlicherweise werden zwangsgeführte Relais zur Realisierung sicherer Schalter verwendet, um mit den Rückführungskontakten der zwangsgeführten Relais einen Kontaktfehler erkennen zu können. Dies ist beispielsweise in DE 100 11 211 A1 beschrieben.

EP 1 453 072 B1 offenbart ein Verfahren zur Überwachung eines elektrischen Kontaktes, der in einem Lastkreis und einen Überwachungskreis vorhanden ist. Hierbei wird eine separate Spannung durch einen optoelektronischen Koppler eingespeist. Die Erkennungseinrichtung ist parallel zu der separaten Spannungsversorgung geschaltet, die wiederum durch den zu überwachenden Schaltkontakt überbrückt wird. Durch Alterung, Temperatur und Bauteiltoleranzen der optoelektronischen Koppler stellt sich das Problem, dass u. U. die Energie für die Überwachung des elektrischen Kontaktes nicht ausreicht.

EP 1 861 860 B1 beschreibt eine Sicherheitsschaltvorrichtung zum sicheren Abschalten eines elektrischen Verbrauchers mit einem Wechselkontakt eines Standardrelais, der einen ersten Schaltpfad zu einem Verbraucher und einen zweiten Schaltpfad zu einem Überwachungskreis schaltet.

Ausgehend hiervon ist es Aufgabe der vorliegenden Erfindung eine verbesserte Überwachungsschaltung zum Erkennen eines Schaltzustandes eines elektrischen Kontaktes in einem Stromversorgungspfad für mindestens einen elektrischen Verbraucher sowie ein verbessertes Verfahren zur Erkennung eines Schaltzustandes eines elektrischen Schaltkontaktes anzugeben.

Die Aufgabe wird durch die Überwachungsschaltung mit den Merkmalen des Anspruchs 1 sowie durch das Verfahren mit den Merkmalen des Anspruchs 6 gelöst. Vorteilhafte Ausführungsformen sind in den Unteransprüchen beschrieben.

Es wird somit eine induktive Trennung des Überwachungsstromkreises von einem Ansteuer- und Rücklesekreis vorgeschlagen. Ein Schließen des mindestens einen überwachten elektrischen Kontaktes führt zu einem Stromfluss im Überwachungsstromkreis, wodurch dem Ansteuer- und Rücklesekreis über die Primärwicklung fließende Energie auf die Sekundärwicklung entzogen wird. Daher kann der Schaltzustand des elektrischen Schaltkontaktes in Abhängigkeit eines durch die Primärwicklung fließenden Stroms bestimmt werden.

Unter einem Übertrager wird ein geeignetes Bauelement verstanden, dem eine galvanische Trennung eines Primär- und Sekundärkreises und eine induktive Energieübertragung von Primärwicklung zu Sekundärwicklung folgt. Die Primärwicklung ist galvanisch von der Sekundärwicklung getrennt. Primär- und Sekundärwicklung sind elektromagnetisch miteinander gekoppelt, z. B. durch Wicklung auf einen gemeinsamen Träger, wie z. B. einem Ferritstab oder Eisenkern zur Bildung eines magnetischen Kreises.

Die Ermittlung einer zu dem durch die Primärwicklung fließenden Strom proportionalen Messgröße erfolgt vorzugsweise dadurch, dass die Primärwicklung mit einem Shuntwiderstand verbunden ist. Die Überwachungseinheit ist dann zur Erfassung der über den Shuntwiderstand abfallenden Spannung zu der durch die Primärwicklung und den Shuntwiderstand fließenden Strom proportionalen Messgröße eingerichtet.

Der Shuntwiderstand ist dabei vorzugsweise in Reihe mit der Primärwicklung geschaltet, so dass der durch die Primärwicklung fließende Strom den durch den Shuntwiderstand fließenden Strom entspricht.

Die Überwachungseinheit ist vorzugsweise zur Erzeugung eines der Primärwicklung des Übertragers aufprägbaren Wechselspannungssignals eingerichtet. Dabei kann es sich um ein sinusförmiges Wechselspannungssignal oder aber auch um ein anderweitig geformtes Wechselspannungssignal handeln, wie beispielsweise ein rechteckförmiges, dreieckförmiges oder anderweitig wechselndes Signal handeln.

Die Überwachungsschaltung kann beispielsweise in eine Steuerungseinheit einer Automatisierungsanlage integriert sein. Damit gelingt auf einfache Weise die kompakte und sichere Überwachung von Schaltkontakten, ohne dass separate Überwachungsmodule vorhanden sein müssen.

Besonders vorteilhaft ist es, wenn die Überwachungseinheit eine Feldbusschnittstelle zur Übermittlung des Schaltzustandes an eine programmierbare Steuerung einer Automatisierungsanlage hat. Damit kann nicht nur lokal das Überwachungsergebnis angezeigt und gegebenenfalls eine Steuerungsmaßnahme getroffen werden. Vielmehr kann durch die Anbindung durch die Überwachungseinheit an eine Feldbusschnittstelle eine Überwachungs- und Warnmeldung an eine übergeordnete Steuerung abgegeben werden, die dann auch für komplexe Anlagen entsprechende Maßnahmen veranlasst.

Vorzugsweise erfolgt ein Erfassen einer über einen Shuntwiderstand abfallenden Spannung mit einem Schwellwertschalter. Ein geöffneter Schaltkontakt wird dann erkannt, wenn die Spannung unter einem vorgegebenen Schwellwert liegt. Dieser Schwellwert ist von der konkreten Bemaßung der Überwachungsschaltung abhängig und kann empirisch ermittelt und festgelegt werden. Damit gelingt eine einfache und zuverlässige Überwachungslogik bei geringst möglichem Aufwand. Nach der Erfindung erfolgt eine Ermittlung der Veränderung der von dem Überwachungsstromkreis aufgenommenen Energie bei vergleichbarem Schaltzustand über die Zeit. So ändert sich über die Betriebsdauer bei geöffneten beziehungsweise bei geschlossenem Schaltkontakt der Kontaktwiderstand und damit die von der Primärseite an den Überwachungsstromkreis abgegebene Energie. Aus den über die Betriebszeit langsamen Änderungen der Messgröße über die proportional zu dem durch die Primärwicklung fließenden Stroms, lässt sich somit ein Maß für den Verschleiß des mindestens einen zu überwachenden Kontaktes feststellen.

Die Erfindung wird nachfolgend anhand der beigefügten Zeichnung anhand eines Ausführungsbeispiels näher erläutert. Es zeigt:

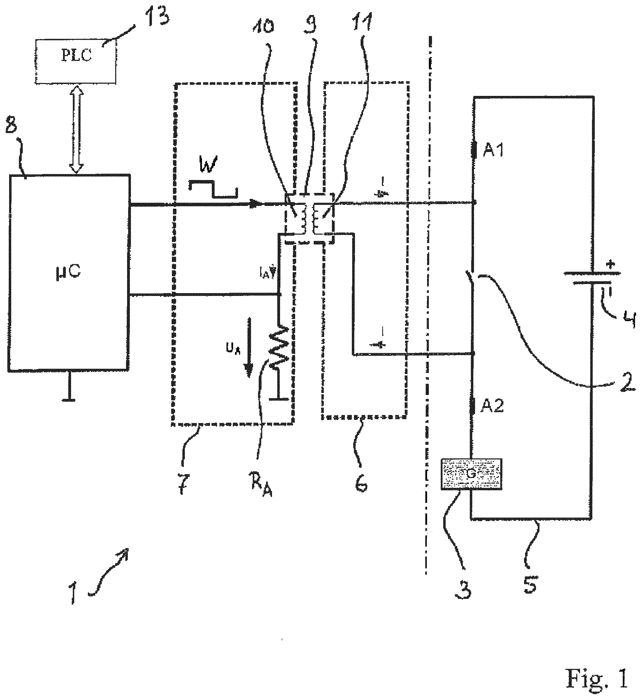

- Figur 1: Schaltbild einer Überwachungsschaltung zum Erkennen eines Schaltzustandes eines elektrischen Schaltkontaktes.

Figur 1 zeigt ein Schaltdiagramm einer Überwachungsschaltung 1, die zum Erkennen des Schaltzustandes eines überwachten Schaltkontaktes 2 eingerichtet ist. Der elektrische Schaltkontakt 2 wird zum Schalten der Energieversorgung eines Gerätes 3 verwendet. Das Gerät 3 ist zusammen mit einer Energieversorgung 4 und gegebenenfalls weiteren Bauelementen wie Strombegrenzungswiderständen A1 und/oder Sicherungen A2 in einem Laststromkreis 5 verschaltet. Der elektrische Schaltkontakt 2 schließt sowohl den Laststromkreis 5 als auch einen Überwachungsstromkreis 6.

Zur Überwachung des Schaltzustandes des überwachten elektrischen Schaltkontaktes 2 in dem Laststromkreis 5 ist ein Ansteuer- und Rücklesekreis 7 vorgesehen, der von einer Überwachungseinheit 8 zum Beispiel in Form eines Mikrocontrollers ASICs, FPGA oder einer speicherprogrammierbaren Steuerung mit einem Wechselsignal W beaufschlagt wird. Der Ansteuer- und Rücklesekreis 7 ist über einen Übertrager 9 unter galvanischer Trennung mit dem Überwachungsstromkreis 6 gekoppelt. Das von der Überwachungseinheit 8 erzeugte Wechselsignal W wird dabei der Primärwicklung 10 des Übertragers 9 zugeführt. Die Sekundärwicklung 11 des Übertragers 9 ist im Überwachungsstromkreis 6 mit dem zu überwachenden elektrischen Schaltkontakt 2 verbunden. Es ist erkennbar, dass der elektrische Schaltkontakt 2 sozusagen parallel zu der Sekundärwicklung 11 geschaltet ist und elektrisch im Überwachungsstromkreis eine Reihenschaltung mit der Sekundärwicklung 11 bildet. Wenn der elektrische Schaltkontakt 2 geöffnet ist, dann ist sowohl der Überwachungsstromkreis 6, als auch der Laststromkreis 5 unterbrochen. Der Übertrager 9 wird in diesem Fall im Leerlauf betrieben und benötigt daher nur wenig Energie und somit zwangsläufig wenig Übertragerstrom I_{A}, der durch die Primärwicklung 10 und einen sich in Reihe daran anschließenden Shuntwiderstand R_{A} fließt. Über diesen Shuntwiderstand R_{A} fällt aufgrund des Übertragerstroms I_{A} eine Spannung U_{A} ab. Diese Spannung U_{A} ist proportional abhängig von dem Übertragerstrom I_{A}.

Wird der elektrische Schaltkontakt 2 geschlossen, dann wird nicht nur der Laststromkreis 5, sondern auch der Überwachungsstromkreis 6 geschlossen. Durch diesen Überwachungsstromkreis 6 fließt dann ein Überwachungsstrom I, der durch den Übertrager 9 gespeist wird. Dieser Stromfluss I entzieht dem Übertrager 9 Energie, wodurch der Übertragerstrom I_{A} im Ansteuer- und Rücklesekreis 7 ansteigt. Der Übertrager 9 wird dann nicht mehr im Leerlauf betrieben, sondern belastet.

Durch den Anstieg des Übertragerstroms I_{A} bei geschlossenem elektrischem Schaltkontakt 2 steigt die Spannung U_{A} über den Shuntwiderstand R_{A} an.

Damit ist die über den Shuntwiderstand R_{A} abfallende Spannung U_{A} ein zu dem durch die Primärwicklung fließenden Stroms I_{A} proportionale Messgröße, die gleichzeitig ein Maß für den Schaltzustand des überwachten elektrischen Schaltkontaktes 2 im Überwachungsstromkreis 6 ist.

Die Überwachungseinheit 8 hat eine separate oder integrierte Messeinheit beispielsweise in Form eines Analog-/Digital-Wandlers, mit dem die über den Shuntwiderstand R_{A} abfallende Spannung U_{A} gemessen wird. Denkbar ist aber auch, dass die Überwachungseinheit 8 einen Schwellwertschalter aufweist, der bei Überschreiten einer vorgegebenen Schwellwertspannung durch die über den Shuntwiderstand R_{A} abfallende Spannung U_{A} in einen anderen Schaltzustand wechselt.

Durch Ermittlung der über den Shuntwiderstand R_{A} abfallenden Spannung U_{A} beziehungsweise gegebenenfalls durch Erkennung einer Grenzwertüberschreitung durch diese Spannung U_{A} kann dann ein Rückschluss auf den Zustand des überwachten elektrischen Schaltkontaktes 2 gezogen werden.

Bei der Umsetzung des analogen Spannungswertes U_{A}, der über dem Shuntwiderstand R_{A} abfällt und zu dem Übertragerstrom I_{A} proportional ist, kann eine differenziertere Auswertung erfolgen. So kann die Überwachungseinheit 8 beispielsweise durch geeignete Programmierung mittels Software oder in Form einer Hardwarelösung mehrere Schwellwerte vorsehen, um auf diese Weise den Übergangswiderstand des elektrischen Schaltkontaktes 2 zu überwachen. Denkbar ist aber auch, dass nur ein Schwellenwert überwacht wird mit dem sicher erkannt werden kann, ob der elektrische Schaltkontakt 2 geöffnet oder geschlossen ist. Dies kann alternativ zu einem Analog-Digital-Umsetzer über einen Schmitt-Trigger mit Hysterese erfolgen.

Es ist auch eine Langzeitüberwachung der über den Shuntwiderstand R_{A} abfallende Spannung U_{A} bei bekanntem Schaltzustand möglich. Wenn sich die Kontaktübergangswiderstände des überwachten elektrischen Schaltkontaktes 2 im Laufe der Zeit verändern, kann ein erhöhter Kontaktwiderstand zu einem abnehmenden Überwachungsstrom I und damit auch zu einem abnehmenden Übertragerstrom PI_{A} führen. Somit kann durch eine Beobachtung der Spannung U_{A} über den Shuntwiderstand R_{A} über einen längeren Betriebszeitraum ein Maß für den Verschleiß des elektrischen Schaltkontaktes 2 bestimmt werden.

Im Ergebnis der Auswertung der über den Shuntwiderstand R_{A} abfallenden Spannung U_{A} mittels einer oder mehrerer Schwellwerte und gegebenenfalls über die Langzeitauswertung kann dann von der Überwachungseinheit 8 eine geeignete Aktion ausgelöst werden. So kann zum Beispiel über eine geeignete Verbindung zu einer übergeordneten Steuerungseinheit beispielsweise mittels Feldbus drahtgebunden oder drahtlos der ermittelte Schaltzustand signalisiert werden. Die Überwachungseinheit 8 oder eine übergeordnete Steuerungseinheit kann dann daraufhin weitere Aktionen auslösen. Solche Aktionen können beispielsweise etwa das Abschalten des den elektrischen Schaltkontakts 2 aufweisenden Relais oder auch das Ausgeben von Warnmeldungen zur Ersetzung des Schalters/Relais sein.

Durch die einfache magnetische Kopplung wird eine einfache Überwachung elektrischer Schaltkontakte mit geringem Aufwand unter galvanischer Trennung des Laststromkreises 5 von dem Auslese- und Rücklesekreis 7 ermöglicht. Bisher verwendete teure zwangsgeführte Relais können durch einfachere Relais mit der vorgeschlagenen Überwachungsschaltung 1 ersetzt werden.

## Patentansprüche

1. Überwachungsschaltung (1) zum Erkennen eines Schaltzustandes und einer Veränderung des Kontaktwiderstandes eines elektrischen Schaltkontaktes (2) in einem Stromversorgungspfad (5) für mindestens einen elektrischen Verbraucher (3), wobei die Überwachungsschaltung (1) eine Überwachungseinheit (8) hat, und die Überwachungsschaltung (1) einen Übertrager (9) mit einer mit der Überwachungseinheit (8) verbundenen Primärwicklung (10) und einer mit dem elektrischen Schaltkontakt (2) verbundenen Sekundärwicklung (11) hat, wobei die Sekundärwicklung (11) mit dem damit elektrisch verbundenen elektrischen Schaltkontakt (2) einen Überwachungsstromkreis (6) bildet, und wobei die Überwachungseinheit (8) zum Aufbringen einer elektrischen Leistung auf die Primärwicklung (10) und zum Bestimmen des Schaltzustandes des elektrischen Schaltkontaktes (2) in Abhängigkeit einer zu dem durch die Primärwicklung (10) fließenden Stroms (I_{A}) proportionalen Messgröße (U_{A}) eingerichtet ist, **dadurch gekennzeichnet, dass** die Überwachungseinheit (8) weiterhin eingerichtet ist zum Erkennen einer Veränderung des Kontaktwiderstandes des elektrischen Schaltkontaktes (2) durch Ermittlung der Veränderung der von dem Überwachungsstromkreis (6) aufgenommenen Energie bei vergleichbarem Schaltzustand des elektrischen Schaltkontaktes (2) über die Zeit.

2. Überwachungsschaltung (1) nach Anspruch 1, **dadurch gekennzeichnet, dass** die Primärwicklung (10) mit einem Shuntwiderstand (R_{A}) verbunden ist und die Überwachungseinheit (8) zur Erfassung der über den Shuntwiderstand (R_{A}) abfallenden Spannung (U_{A}) als zu der durch die Primärwicklung (10) und den Shuntwiderstand (R_{A}) fließenden Strom (I_{A}) proportionalen Messgröße eingerichtet ist.

3. Überwachungsschaltung (1) nach Anspruch 1 oder 2, **dadurch gekennzeichnet, dass** die Überwachungseinheit (8) zur Erzeugung eines der Primärwicklung (10) des Übertragers (9) aufprägbaren Wechselspannungssignals (W) eingerichtet ist.

4. Überwachungsschaltung (1) nach einem der vorhergehenden Ansprüche, **dadurch gekennzeichnet, dass** die Überwachungseinheit (8) eine Feldbusschnittstelle (12) zur Übermittlung des Schaltzustandes an eine programmierbare Steuerung (13) einer Automatisierungsanlage hat.

5. Steuerungseinheit (13) für eine Automatisierungsanlage, wobei in der Steuerungseinheit (13) eine Überwachungsschaltung (1) nach einem der vorhergehenden Ansprüche integriert ist.

6. Verfahren zur Erkennung eines Schaltzustandes eines elektrischen Schaltkontaktes (2) in einem Stromversorgungspfad (5) für mindestens einen elektrischen Verbraucher, durch ein elektromagnetisches Einkoppeln von Energie von einem Auswertekreis (7) einer Überwachungseinheit (8) in einen galvanisch von dem Auswertekreis (7) getrennten Überwachungsstromkreis (6), der mit dem zu überwachenden elektrischen Schaltkontakt (2) verbunden ist, und ein Bestimmen des Schaltzustandes des elektrischen Schaltkontaktes (2) in Abhängigkeit von der von dem Überwachungsstromkreis (6) aufnehmbaren Energiemenge, **gekennzeichnet durch** ein Erkennen einer Veränderung des Kontaktwiderstandes des elektrischen Schaltkontaktes (2) durch Ermittlung der Veränderung der von dem Überwachungsstromkreis (6) aufgenommenen Energie bei vergleichbarem Schaltzustand des elektrischen Schaltkontaktes (2) über die Zeit.

7. Verfahren nach Anspruch 6, **gekennzeichnet durch** Anlegen einer Wechselspannung (W) an die Primärwicklung (10) eines Übertragers (9), dessen Sekundärwicklung (11) zur Bildung des Überwachungsstromkreises (6) parallel zu dem elektrischen Schaltkontakt (2) angeschlossen ist, Erfassen des durch die Primärwicklung (10) fließenden Stroms (I_{A}) als Maß für die von dem Überwachungsstromkreis (6) aufgenommene Energie und Erkennen eines geschlossenen Schaltkontaktes (2), wenn der erfasste Strom (I_{A}) höher als bei geöffnetem Schaltkontakt (2) ist.

8. Verfahren nach Anspruch 7, **gekennzeichnet durch** Erfassen der über einen mit der Primärwicklung (10) in Reihe geschalteten Shuntwiderstandes (R_{A}) abfallenden Spannung (U_{A}) als Maß für den durch die Primärwicklung (10) und den Shuntwiderstand (R_{A}) fließenden Stroms (I_{A}) und die von dem Überwachungsstromkreis (6) aufgenommene Energie.

9. Verfahren nach Anspruch 6, **gekennzeichnet durch** Erfassen der über den Shuntwiderstand (R_{A}) abfallenden Spannung(u_{A}) mit einem Schwellwertschalter und Erkennen eines geöffneten Schaltkontaktes (2), wenn die Spannung (U_{A}) unter einem vorgegebenen Schwellwert liegt.

## Claims

1. Monitoring circuit (1) for detecting a switching state and a change of a contact resistance of an electrical switching contact (2) in a current supply path (5) for at least one electrical load (3), whereby the monitoring circuit (1) comprises a monitoring unit (8), and
the monitoring circuit (1) comprises a transformer (9), that has a primary winding (10), which is connected to the monitoring unit (8), and has a secondary winding (11), which is connected to the electrical switching contact (2), wherein
the secondary winding (11) forms a monitoring current circuit (6) together with the thereby electrically connected electrical switching contact (2), and wherein
the monitoring unit (8) is adopted to apply electrical power to the primary winding (10) and to determine the switching state of the electrical switching contact (2) in dependence on a measured value (U_{A}) that is proportional to the current (I_{A}) flowing through the primary winding (10), **characterized in that**
the monitoring unit (8) is further adapted to determine a change of the contact resistance of the electrical switching contact (2) by detection of the change of the energy received by the monitoring current circuit (6) during comparable switching state of the electrical switching contact (2) over the time.

2. Monitoring circuit (1) according to claim 1, **characterized in that** the primary winding (10) is connected to a shunt resistor (R_{A}) and the monitoring unit (8) is adopted for the acquisition of the voltage drop (U_{A}) across the shunt resistor (R_{A}), as the measurement value that is proportional to the current (I_{A}) flowing through the primary winding (10) and the shunt resistor (R_{A}).

3. Monitoring circuit (1) according to claim 1 or 2, **characterized in that** the monitoring unit (8) is adopted for the generation of an alternating voltage signal (W), that is applicable to the primary winding (10) of the transformer (9).

4. Monitoring circuit (1) according to any one of the preceding claims, **characterized in that**
the monitoring unit (8) comprises a field bus interface (12) for the transmission of the switching state to a programmable controller (13) of an automation system.

5. Control unit (13) of an automation system, wherein in the control unit (13) a monitoring circuit (1) according to any one of the preceding claims is integrated.

6. Method for detecting a switching state of an electrical switching contact (2) in a current supply path (5) for at least one electrical load, by an electromagnetic coupling of energy from an evaluation circuit (7) of a monitoring unit (8) into a monitoring current circuit (6), that is galvanically separated from the evaluation circuit (7), and that is connected to the electrical switching contact (2) to be monitored, and determining the switching state of the electrical switching contact (2) in dependence on the amount of energy receivable by the monitoring current circuit (6); **characterized by**
determining a change of the contact resistance of the electrical switching contact (2) by detection of the change of the energy received by the monitoring current circuit (6) during comparable switching state of the electrical switching contact (2) over the time.

7. Method according to claim 6, **characterized by**
supplying an alternating voltage (W) to the primary winding (10) of a transformer (9), whose secondary winding (11), for the generation of the monitoring current circuit (6), is connected in parallel to the electrical switching contact (2), acquiring the current (I_{A}) flowing through the primary winding (10) as a measure for the energy received by the monitoring current circuit (6) and detecting a closed switching contact (2), if the measured current (I_{A}) is higher than in case of an open switching contact (2).

8. Method according to claim 7, **characterized by**
acquiring the voltage drop (U_{A}) across a shunt resistor (R_{A}) that is connected in series with the primary winding (10), as a measure for the current (I_{A}) flowing though the primary winding (10) and the shunt resistor (R_{A}) and the energy received by the monitoring current circuit (6).

9. Method according to claim 6, **characterized by**
acquiring the voltage drop (U_{A}) across the shunt resistor (R_{A}) by means of a threshold switch and determining an open switching contact (2), if the voltage (U_{A}) is below a predetermined threshold.

## Revendications

1. Circuit de surveillance (1) pour repérer un état de commutation et une modification de la résistance de contact d'un contact de commutation électrique (2) dans un trajet d'alimentation en courant (5) d'au moins un organe utilisateur électrique (3), le circuit de surveillance (1) possédant une unité de surveillance (8), et le circuit de surveillance (1) possédant un transformateur (9) avec un enroulement primaire (10) relié à l'unité de surveillance (8) et un enroulement secondaire (11) relié au contact de commutation électrique (2), l'enroulement secondaire (11) formant avec le contact de commutation électrique (2) qui y est relié électriquement un circuit de surveillance (6), et l'unité de surveillance (8) étant agencée pour appliquer une puissance électrique à l'enroulement primaire (10) et pour déterminer l'état de commutation du contact de commutation électrique (2) en fonction d'une grandeur mesurée (U_{A}) proportionnelle au courant (I_{A}) parcourant l'enroulement primaire (10), **caractérisé en ce qu'**en outre l'unité de surveillance (8) est agencée pour repérer une modification de la résistance de contact du contact de commutation électrique (2) par détection de la modification de l'énergie absorbée par le circuit de surveillance (6) à état de commutation comparable du contact de commutation électrique (2) en fonction du temps.

2. Circuit de surveillance (1) selon la revendication 1, **caractérisé en ce que** l'enroulement primaire (10) est relié à une résistance shunt (R_{A}) et l'unité de surveillance (8) est agencée pour enregistrer la tension (U_{A}) décroissant à travers la résistance shunt (R_{A}) en tant que grandeur mesurée proportionnelle au courant (I_{A}) parcourant l'enroulement primaire (10) et la résistance shunt (R_{A}).

3. Circuit de surveillance (1) selon la revendication 1 ou 2, **caractérisé en ce que** l'unité de surveillance (8) est agencée pour produire un signal de tension alternative (W) applicable à l'enroulement primaire (10) du transformateur (9).

4. Circuit de surveillance (1) selon une des revendications précédentes, **caractérisé en ce que** l'unité de surveillance (8) possède une interface de bus de terrain (12) pour transmettre l'état de commutation à une commande programmable (13) d'une installation d'automatisation.

5. Unité de commande (13) pour une installation d'automatisation, dans l'unité de commande (13) étant intégré un circuit de surveillance (1) selon une des revendications précédentes.

6. Procédé pour repérer un état de commutation d'un contact de commutation électrique (2) dans un trajet d'alimentation en courant (5) pour au moins un organe utilisateur électrique, par couplage électromagnétique d'énergie d'un circuit d'analyse (7) d'une unité de surveillance (8) dans un circuit de surveillance (6) qui est séparé galvaniquement du circuit d'analyse (7) et qui est relié au contact de commutation électrique (2) à surveiller, et par détermination de l'état de commutation du contact de commutation électrique (2) en fonction de la quantité d'énergie absorbable par le circuit de surveillance (6), **caractérisé par** un repérage d'une modification de la résistance de contact du contact de commutation électrique (2) par détection de la modification de l'énergie absorbée par le circuit de surveillance (6) à état de commutation comparable du contact de commutation électrique (2) en fonction du temps.

7. Procédé selon la revendication 6, **caractérisé par** l'application d'une tension alternative (W) à l'enroulement primaire (10) d'un transformateur (9) dont l'enroulement secondaire (11) est relié en parallèle au contact de commutation électrique (2) pour former le circuit de surveillance (6), par l'enregistrement du courant (I_{A}) parcourant l'enroulement primaire (10) comme mesure de l'énergie absorbée par le circuit de surveillance (6), et par le repérage d'un contact de commutation (2) fermé lorsque le courant (I_{A}) enregistré est plus élevé qu'à contact de commutation (2) ouvert.

8. Procédé selon la revendication 7, **caractérisé par** l'enregistrement de la tension (U_{A}) décroissant à travers la résistance shunt (R_{A}) montée en série avec l'enroulement primaire (10) comme mesure du courant (I_{A}) parcourant l'enroulement primaire (10) de la résistance shunt (R_{A}) et de l'énergie absorbée par le circuit de surveillance (6).

9. Procédé selon la revendication 6, **caractérisé par** l'enregistrement de la tension (U_{A}) décroissant à travers la résistance shunt (R_{A}) avec un commutateur à valeur de seuil, et le repérage d'un contact de commutation (2) ouvert lorsque la tension (U_{A}) est inférieure à une valeur de seuil prédéfinie.
